# EUROPEAN PATENT APPLICATION

(11) **EP 4 404 388 A1**
(43) Date of publication of application: **24.07.2024**
(21) Application number: 24151546.9
(22) Date of filing: 12.01.2024
(51) Int. Cl.: H01R 12/58, H05K 1/00, B23K 1/00, H01R 43/16, H01R 13/03

(54) **METHOD FOR PROCESSING CONDUCTIVE TERMINAL AND ELECTRICAL ASSEMBLY**

(30) Priority: 20.01.2023 CN 202310079738
(71) Applicant: Robert Bosch GmbH, 70442 Stuttgart (DE)
(72) Inventor: QI, Zhenhua, Jiangsu, 215021 (CN)

(57) **Abstract**

The present application provides a method for processing a conductive terminal and an electrical assembly. The method for processing a conductive terminal includes: determining a contact region on a terminal to have a press-fit connection with a circuit board, the contact region including a tin-containing layer; generating laser light using one or more lasers, and projecting the laser light to the contact region; and subjecting the contact region to laser irradiation for a predetermined time, the tin-containing layer in the contact region undergoing melting, diffusion and re-solidification during the laser irradiation, and a tin-containing intermetallic compound being formed on an outer surface of the contact region. The method for processing a conductive terminal and the electrical assembly of the present application have advantages such as simple implementation, convenient deployment, and good performance.

## Description

### TECHNICAL FIELD

The present application relates to the field of terminal processing processes. More specifically, the present application relates to a method for processing a conductive terminal, which aims to reduce the likelihood of whisker formation. The present application further relates to an electrical assembly comprising a terminal obtained by the described preprocessing method.

### BACKGROUND

Some electrical elements are connected to circuit boards by using tin-containing terminals, e.g., by means of soldering and press-fit. The tin-containing terminals tend to form whiskers during connection, and the whiskers may result in undesired effects. For example, tin whiskers may cause short circuits and limit the application scenarios of press-fit connection technology. Therefore, there is ongoing demand in the art to reduce the likelihood of tin whisker formation. For example, a reflow process based on oven heating can be used to perform heat treatment on terminals. For another example, it is possible to adopt connection solutions that use terminals not containing pure tin.

### SUMMARY

In one aspect, the objective of the present application is to provide a method for processing a conductive terminal, which aims to mitigate the generation of tin whiskers during terminal connection. In another aspect, the objective of the present application is to provide an electrical assembly comprising a terminal obtained by the described preprocessing method.

The objectives of this application are achieved by using the following technical solutions.

A method for processing a conductive terminal, comprising:
Determining a contact region on a terminal to have a press-fit connection with a circuit board, the contact region comprising a tin-containing layer;
Generating laser light using one or more lasers, and projecting the laser light to the contact region; and
Subjecting the contact region to laser irradiation for a predetermined time;
Wherein the tin-containing layer in the contact region undergoes melting, diffusion and re-solidification during the laser irradiation, and a tin-containing intermetallic compound is formed on an outer surface of the contact region.

In the described method for processing a conductive terminal, optionally, the terminal comprises:
An intermediate layer, containing a conductive metal as a terminal base material;
A first layer, covering the intermediate layer and containing nickel; and
A second layer, covering the first layer and containing tin.

In the described method for processing a conductive terminal, optionally, the conductive metal comprises one or more of the following components: iron, copper, silver, gold, copper alloy, and silver alloy.

In the described method for processing a conductive terminal, optionally, the wavelength of the laser light and the predetermined time of the laser irradiation are selected such that at the contact region, the temperature of the second layer rises above the melting point of tin and the second layer melts, and then the tin from the second layer and the nickel from the first layer mutually diffuse and then are re-solidified, so as to form an intermetallic compound containing nickel and tin at the outer surface of the contact region.

In the described method for processing a conductive terminal, optionally, the terminal is subsequently connected to the circuit board, such that the contact region is electrically connected to a conductor on the circuit board in a cold connection manner.

In the described method for processing a conductive terminal, optionally, the contact region is arranged around the periphery of the terminal, and when the one or more lasers and the terminal rotate relative to each other, the entirety of the contact region at the periphery of the terminal is irradiated using the laser light; or, the contact region comprises a particular position on the terminal, and when the one or more lasers and the terminal are fixed relative to each other, the contact region is irradiated using the laser light.

In the described method for processing a conductive terminal, optionally, the terminal comprises:
Two contact portions, each comprising the contact region; and
A yielding portion, positioned between the contact portions, and at least partially deforming when the terminal is inserted into the circuit board, so that the contact portions fit with a mounting hole on the circuit board;
Wherein the yielding portion has one of the following forms: a through-hole, a wavy profile comprising a series of protrusions and depressions, and a profile comprising an irregular distribution of protrusions and depressions.

Provided is an electrical assembly, comprising:
A circuit board comprising one or more mounting holes, an inner wall of each mounting hole comprising a conductive conductor; and
An electrical element comprising one or more terminals inserted into the mounting holes, each terminal comprising a tin-containing layer, and a contact region in contact with the conductor of the inner wall of the mounting hole;
Wherein before the terminal is connected to the circuit board, the contact region of the terminal is subjected to laser irradiation, and undergoes melting, diffusion and re-solidification to form a tin-containing intermetallic compound layer on an outer surface of the contact region, and the intermetallic compound layer covers the contact region, so that the contact region has a reduced tin whisker formation rate when the terminal is connected to the circuit board.

In the described electrical assembly, optionally, the terminal comprises:
An intermediate layer, containing a conductive metal as a terminal base material;
A first layer, covering the intermediate layer and containing nickel; and
A second layer, covering the first layer and containing tin.

In the described electrical assembly, optionally, the wavelength and predetermined time of the laser irradiation are selected such that at the contact region, the temperature of the second layer rises above the melting point of tin and melting occurs, and then the tin from the second layer and the nickel from the first layer mutually diffuse and then are re-solidified to form an intermetallic compound layer containing nickel and tin, wherein the intermetallic compound layer is larger than the contact region.

### BRIEF DESCRIPTION OF THE DRAWINGS

The following further describes this application in detail with reference to accompanying drawings and preferred embodiments. A person skilled in the art would understand that these accompanying drawings are only intended to facilitate understanding of the preferred embodiments, and should not be construed as limiting the scope of the present application. In addition, unless otherwise specified, the accompanying drawings are only intended to conceptually represent the composition or construction of the described objects and may include exaggerated displays. The accompanying drawings are also not necessarily drawn to scale.
FIG. 1 is a schematic diagram of a method for processing a conductive terminal according to an embodiment of the present application.
FIG. 2 is a partial enlarged cross-sectional view of part B shown in FIG. 1.
FIG. 3 is a schematic cross-sectional view of an electrical assembly during assembly according to an embodiment of the present application.
FIG. 4 is a partial cross-section of a top view of the embodiment shown in FIG. 3.

### DETAILED DESCRIPTION

The following describes preferred embodiments of this application in detail with reference to accompanying drawings. A person skilled in the art would understand that these descriptions are only illustrative and exemplary, and should not be construed as limiting the scope of protection of the present application.

First, it should be noted that position terms mentioned in this specification such as top, bottom, upward, downward are defined relative to directions in the accompanying drawings. These positions are relative concepts, and thus may vary according to the position and state in which they are located. Therefore, these or other position terms should not be understood as limiting.

Further, it should further be noted that for any single technical feature described or implied in the embodiments herein or any single technical feature shown or implied in the accompanying drawings, these technical features (or equivalents thereof) can continue to be combined, thereby obtaining other embodiments that are not directly mentioned herein.

It should be noted that in different accompanying drawings, the same reference numbers indicate identical or substantially identical components.

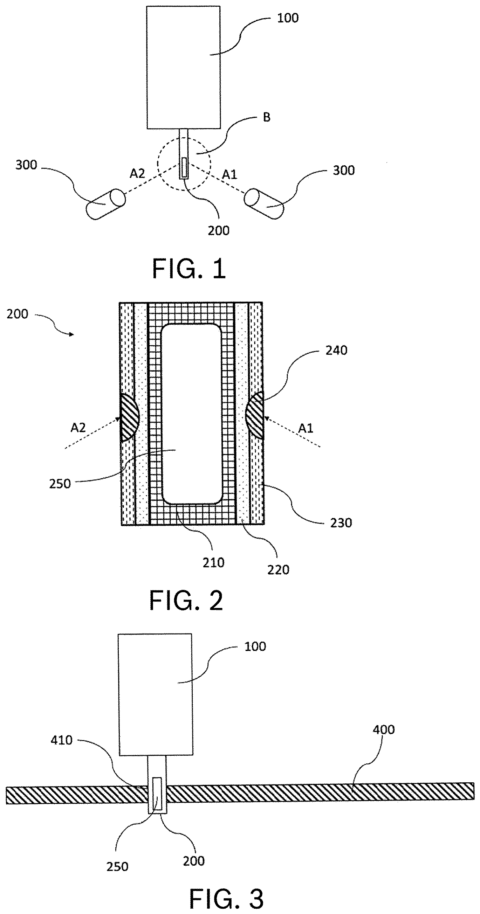

FIG. 1 is a schematic diagram of a method for processing a conductive terminal according to an embodiment of the present application, and FIG. 2 is a partial enlarged cross-sectional view of part B shown in FIG. 1. The state shown in FIG. 1 is a step of the method for processing a conductive terminal of the present application. For the sake of clarity, an electrical element 100, a terminal 200, and lasers 300 are shown in FIGS. 1 and 2. The terminal 200 may extend from the electrical element 100, and the lasers 300 may be oriented toward a portion of the terminal 200. More specifically, the lasers 300 may be oriented toward a contact region on the terminal 200 that is to be fit with a circuit board 400, which will be described in detail below.

The present application relates to a method for preprocessing the terminal 200. According to one embodiment of the present application, the method for preprocessing the terminal 200 includes: positioning a contact region on the terminal 200 to have press-fit connection with the circuit board 400; generating laser light using one or more lasers 300 and projecting the laser light to the contact region; and irradiating the contact region for a predetermined length of time.

The terminal 200 is typically disposed at an end of the electrical element 100, that is, extending from an end of the electrical element 100. The contact region on the terminal 200 to have a press-fit connection with the circuit board 400 may be determined in advance. In one embodiment, the contact region may be a portion of a material strip. In one embodiment, the terminal 200 may have a generally cylindrical profile, and the contact region may be an annular region at the periphery of the terminal 200. For example, the terminal 200 may be sized and configured to establish a mechanical connection and an electrical connection in a press-fit manner with a through-hole (PTH) on the circuit board 400, the contact region being a portion of the terminal 200 in contact with the circuit board 400. In one embodiment, the terminal 200 may be a plate-shaped structure, and two sides or two ends of the terminal 200 when viewed in cross-section have a press-fit connection with the circuit board 400.

FIG. 1 shows, in an exemplary manner, the state when laser light is projected to the contact region. In the illustrated embodiment, the terminal 200 extends from an end of the electrical element 100, and at least a portion of the terminal 200 is marked as the contact region. In the illustrated embodiment, the contact region is schematically illustrated in black. It may be easily understood that the terminal 200 may be positioned such that the contact region is accessible to the laser light. For example, the electrical element 100 may be fixed in place, e.g., fixed to a transport apparatus, and the terminal 200 extending from the electrical element 100.

The one or more lasers 300 may be positioned relative to the terminal 200. For example, FIG. 1 shows two lasers 300, each emitting laser light toward the contact region on the terminal 200. The paths of the laser light are schematically illustrated using dashed lines A1 and A2. In one embodiment, the lasers 300 and the terminal 200 are movable relative to each other. For example, the lasers 300 may be rotated in space using the terminal 200 as the axis, so that laser light easily irradiates the entire periphery of the terminal 200. For another example, the electrical element 100 and the terminal 200 may be positioned to be rotatable in space using the terminal 200 as the axis, so that the entire periphery of the terminal 200 may be easily subjected to laser irradiation. In one embodiment, the contact region is a particular portion on the terminal 200, such as points at two sides of the terminal when viewed in cross-section. In this case, when the lasers 300 are fixed relative to the terminal 200, the laser light is projected onto the contact region.

The type, wavelength, and power of the laser light of the lasers 300 may be suitably selected such that the contact region at least partially undergoes melting, diffusion and re-solidification during the laser irradiation. In one embodiment, the contact region includes a tin-containing layer. In one embodiment, respective layers may be laid at the periphery of the terminal 200 by means of electroplating.

As shown in FIG. 2, the terminal 200, when viewed in cross-section, may include a plurality of portions, including, for example, an intermediate layer 210, a first layer 220, a second layer 230, etc. The intermediate layer 210 may include a conductive metal as a terminal base material, and has the function of transmitting electrical signals. In one embodiment, the conductive metal may include one or more of the following components: iron, copper, silver, gold, copper alloy, silver alloy, etc. The first layer 220 and the second layer 230 may be disposed on the surface of the intermediate layer 210. In one embodiment, the first layer 220 is disposed between the second layer 230 and the intermediate layer 210. In one embodiment, the first layer 220 and the second layer 230 may be electroplated layers. In other words, the first layer 220 and the second layer 230 may be sequentially applied onto the outer surface of the intermediate layer 210 by a process such as electroplating. The second layer 220 is a nickel plating layer containing nickel, and the third layer 230 is a tin plating layer containing tin. For example, the third layer 230 is made of pure tin. In one embodiment, the terminal 200 may further include a through-hole 250, the through-hole 250 extending through the terminal 200, and possibly extending through the intermediate layer 210. In FIGS. 1 and 2, the through-hole 250 is schematically illustrated in the form of a rectangular block. As a terminal for press-fit connection, the terminal 200 typically has a plate-shaped cross-section and a reduced end portion, and the through-hole 250 may extend through the plate-shaped cross-section.

Further, in one embodiment, the terminal 200 may be configured to be solid, one or more protrusions being provided on the outer surface of the terminal 200. The protrusions may be irregularly distributed.

In summary, the terminal 200 may include a yielding portion and two contact portions. The contact portions may include, for example, the contact region described herein, and may be disposed on two sides of the yielding portion. For example, the contact portions may include surfaces at two sides of the terminal 200 as shown in FIG. 2, e.g., including at least the region where the third layer 230 is located. The yielding portion may be disposed at the middle of the terminal 200 and located between the two contact portions, and may at least partially deform in the process of inserting the terminal 200 into a mounting hole on the circuit board, so that the outer surface of the contact portion may easily adapt to the profile of the mounting hole.

In one embodiment, the yielding portion may be the through-hole 250 shown in FIG. 2. In one embodiment, the yielding portion may include a curved profile formed by the terminal 200, such as a wavy profile consisting of a series of protrusions and depressions. In one embodiment, the yielding portion includes a series of irregular protrusions and depressions. The shape of the yielding portion is configured such that the yielding portion can at least partially deform.

In addition, in FIGS. 1 and 2, the bottom of the terminal 200 is shown to have a rectangular profile. However, according to actual need, the bottom of the terminal 200 may be configured to have a tapered or pointed shape. For example, the bottom of the terminal 200 may be configured to have a gradually reducing tapered or needle shape. For another example, the two sides of the terminal 200 in FIGS. 1 and 2 may protrude to the left and the right, respectively, so as to form a blade shape, that is, to form a gradually reduced or expanded shape from the perspective of FIG. 2.

It may be easily understood that the structure of the terminal 200 shown in FIG. 2 is merely exemplary. In practice, the terminal 200 may have a variety of different structures including, but not limited to, plate-shaped, cylindrical, etc. For example, the plate-shaped terminal may have an intermediate layer having a rectangular cross-section, and a layer covering the intermediate layer and containing at least tin. The plate-shaped terminal may also be subjected to pre-processing by laser irradiation, and achieve technical effects similar to those of the embodiments set forth in the present application.

With continued reference to FIG. 2, as shown in the figure, at least a portion of the surface of the second layer 230 constitutes the contact region, and the surface of the second layer 230 is subjected to laser irradiation to form a third layer 240. In one embodiment, the third layer 240 is substantially equivalent to the contact region. In one embodiment, tin in the third layer 240 undergoes melting, diffusion and re-solidification during the laser irradiation, and thus has an onlooker structure and a metallographic composition different from those of the rest of the second layer 230. In one embodiment, the energy density and irradiation time of laser light A1 and A2 are selected such that the temperature of the tin in the second layer 230 rises above the melting point of tin (231 °C), but the temperature of the first layer 220 does not rise above the melting point of nickel (1453°C). This configuration allows the second layer 230 to melt while the first layer 220 at least does not experience large-area melting. For example, the nickel in the first layer 220 may at least partially diffuse into the molten tin in the second layer 230, so that the tin and the nickel are mixed to form a mixture. The mixture is then cooled and re-solidified to form the third layer 240. Such a diffusion process may occur during the laser irradiation, or at least part of the process may occur before the laser irradiation. For example, if the terminal 200 is stored at room temperature for a period of time, then the nickel in the first layer 220 and the tin in the second layer 230 tend to mutually diffuse to form an intermetallic compound having a metallographic structure dominated by NiSn₃. However, the shape of the intermetallic compound stored at room temperature is more irregular, presenting a needle-like distribution, and a large amount of pure tin may still remain on the outer surface of the terminal 200, so that the problem of tin whisker formation may still occur during press-fit mounting.

In one embodiment, the re-solidification in the second layer 230 may occur within a predetermined time after the melting. In other words, the re-solidification occurs with a delay after the melting. As shown in FIG. 2, the third layer 240 may extend at least partially into the first layer 220, and extend through the second layer 230. In an actual metallographic structure, the interfaces between the first layer, the second layer, and the third layer may not be straight lines, as shown in FIG. 2, but rather may have a transition structure with mutual diffusion. For example, irregular intermetallic compounds may be formed at the interfaces between the first layer, the second layer and the third layer.

In one embodiment, the third layer is also referred to as a tin-containing intermetallic compound layer, and the tin-containing intermetallic compound layer may cover the contact region. For example, the coverage range of the tin-containing intermetallic compound layer may be greater than or equal to that of the contact region.

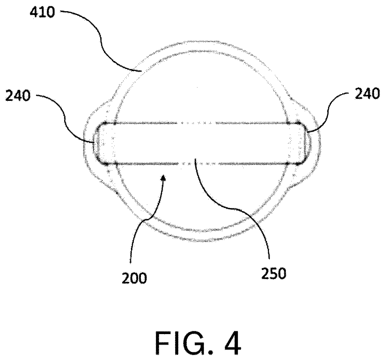

The operation in which the contact region on the second layer 230 undergoes melting, diffusion and re-solidification is also referred to as laser-reflow. Such an operation will form a tin-containing intermetallic compound on the outer surface of the contact region. In one embodiment, the tin layer is rapidly transformed to form a dense and regular intermetallic compound dominated by Ni₃Sn₄. The applicant has experimentally determined that the third layer 240 produced by laser reflow preprocessing will have a reduced whisker formation rate, e.g., a reduced tin whisker formation rate. The tin-containing intermetallic compound will tend to not form, or form fewer, tin whiskers during subsequent assembly processes. It may be easily understood that the third layer 240 may extend around the periphery of the terminal 200 and be configured to cover a generally annular region, or may cover one or more points at the periphery of the terminal 200, e.g., two opposite segments on a cross-section of the cover terminal 200. During assembly, the periphery of the terminal 200 partially contacts a mounting hole 410 on the circuit board 400 to form a press-fit. The segment for the press-fit may be a point or a block. FIG. 3 is a schematic cross-sectional view of an electrical assembly during assembly according to an embodiment of the present application, and FIG. 4 is a partial cross-section of a top view of the embodiment shown in FIG. 3. The electrical assembly may include an electrical element 100 and a circuit board 400. The electrical element 100 may include one or more terminals 200, and the circuit board 400 may include corresponding mounting holes 410. The terminal 200 may fit into the mounting hole 410, and have a press-fit connection thereto. In one embodiment, a conductive material may be arranged on the inner wall of the mounting hole 410, and the terminal 200 establishes a mechanical connection and an electrical connection with the inner wall of the mounting hole 410. In one embodiment, the conductive material on the inner wall of the mounting hole 410 may include hole-plating copper and a copper protective layer. For another example, the inner wall of the mounting hole 410 may include a conductive conductor. More specifically, the terminal 200 may be a terminal processed using the preprocessing method set forth above, and thus include a third layer 240. The third layer 240 may constitute at least a portion of the contact region of the terminal 200. The third layer 240 or the contact region may be in contact with the conductive material on the inner wall of the mounting hole 410. In other words, the contact region may be in contact with the conductive conductor on the inner wall of the mounting hole 410.

In one embodiment, the contact region and the conductive conductor on the inner wall of the mounting hole 410 on the circuit board 400 are electrically connected in a cold connection manner. The cold connection herein refers to a connection that does not require the application of heat from the outside. The opposite of a cold connection is a hot connection. For example, in a soldering process, it is typically necessary to apply heat to a material and to melt the material. Therefore, soldering can be considered a hot connection.

As shown in FIG. 4, the mounting hole 410 has a circular profile, and a conductive metal, such as a conductive metal layer, is provided on the inner wall of the mounting hole 410. The terminal 200 shown in FIG. 4 has an elongated cross-section, and includes a through-hole 250 (schematically shown by dashed lines) located in the middle of the cross-section, and a third layer 240 or a contact region at two sides of the cross-section. During mounting, the terminal 200 is inserted directly into the mounting hole 410, and the third layer 240 or the contact region located at two sides of the cross-section contacts the conductive metal on the inner wall of the mounting hole 410 to form a press-fit. FIG. 4 shows, in an exaggerated manner, the deformation at the contact location between the third layer 240 or the contact region and the conductive metal on the inner wall of the mounting hole 410. In this way, a mechanical connection and an electrical connection are established between the third layer 240 or the contact region and the inner wall of the mounting hole 410.

It may be easily understood that the third layer 240 or the contact region may include a tin-containing layer, and is processed by the preprocessing method described above before assembly, so that tin and nickel at least partially undergo melting, diffusion and re-solidification, so as to form a tin-containing intermetallic compound on the outer surface of the contact region. According to an embodiment of the present application, the third layer 240 or the contact region has a reduced tin whisker formation rate when the terminal 200 is connected to the circuit board 400. Therefore, the method for processing a conductive terminal of the present application effectively reduces the formation of tin whiskers, thereby avoiding short circuits and other undesirable technical problems. The method for processing a conductive terminal of the present application can be used to preprocess a variety of tin-containing terminals.

By adopting the preprocessing technique of the present application, the risk of producing tin whiskers can be effectively reduced, thereby improving the connection reliability and safety of electrical assemblies.

This specification discloses this application with reference to the accompanying drawings, and also enables a person skilled in the art to practice this application, including manufacturing and using any apparatus or system, selecting appropriate materials, and using any incorporated method. The scope of this application is defined by the technical solutions claimed, and includes other examples that occur to a person skilled in the art. As long as such other examples include structural elements that are not different from the literal language of the claimed technical solution, or such other examples include equivalent structural elements that do not substantially different from the literal language of the claimed technical solution, such other examples should be considered within the scope of protection determined by the technical solutions claimed in this application.

## Claims

1. A method for processing a conductive terminal, **characterized by** comprising:
determining a contact region on a terminal (200) to have a press-fit connection with a circuit board (400), the contact region comprising a tin-containing layer;
generating laser light using one or more lasers (300), and projecting the laser light to the contact region; and
subjecting the contact region to laser irradiation for a predetermined time;
wherein the tin-containing layer in the contact region undergoes melting, diffusion and re-solidification during the laser irradiation, and a tin-containing intermetallic compound is formed on an outer surface of the contact region.

2. The method for processing a conductive terminal according to claim 1, **characterized in that** the terminal (200) comprises:
an intermediate layer (210), containing a conductive metal as a terminal base material;
a first layer (220), covering the intermediate layer (210) and containing nickel; and
a second layer (230), covering the first layer (220) and containing tin.

3. The method for processing a conductive terminal according to claim 2, **characterized in that** the conductive metal comprises one or more of the following components: iron, copper, silver, gold, copper alloy, and silver alloy.

4. The method for processing a conductive terminal according to claim 2, **characterized in that** the wavelength of the laser light and the predetermined time of the laser irradiation are selected such that at the contact region, the temperature of the second layer (230) rises above the melting point of tin and the second layer melts, and then the tin from the second layer (230) and the nickel from the first layer (220) mutually diffuse and then are re-solidified, so as to form an intermetallic compound containing nickel and tin at the outer surface of the contact region.

5. The method for processing a conductive terminal according to claim 4, **characterized in that** the terminal (200) is subsequently connected to the circuit board (400), such that the contact region is electrically connected to a conductor on the circuit board (400) in a cold connection manner.

6. The method for processing a conductive terminal according to any one of claims 1-5, **characterized in that** the contact region is arranged around the periphery of the terminal (200), and when the one or more lasers (300) and the terminal (200) rotate relative to each other, the entirety of the contact region at the periphery of the terminal (200) is irradiated using the laser light; or, the contact region comprises a particular position on the terminal (200), and when the one or more lasers (300) and the terminal (200) are fixed relative to each other, the contact region is irradiated using the laser light.

7. The method for processing a conductive terminal according to any one of claims 1-5, **characterized in that** the terminal (200) comprises:
two contact portions each comprising the contact region; and
a yielding portion, positioned between the contact portions, and at least partially deforming when the terminal (200) is inserted into the circuit board (400), so that the contact portions fit with a mounting hole (410) on the circuit board (400);
wherein the yielding portion has one of the following forms: a through-hole (250), a wavy profile comprising a series of protrusions and depressions, and a profile comprising an irregular distribution of protrusions and depressions.

8. An electrical assembly, **characterized by** comprising:
a circuit board (400) comprising one or more mounting holes (410), wherein an inner wall of each mounting hole (410) comprises a conductive conductor; and
an electrical element (100) comprising one or more terminals (200), the terminals (200) inserted into the mounting holes (410), and each terminal (200) comprising a tin-containing layer and a contact region in contact with the conductor of the inner wall of the mounting hole (410);
wherein before the terminal (200) is connected to the circuit board (400), the contact region of the terminal (200) is subjected to laser irradiation, and undergoes melting, diffusion and re-solidification to form a tin-containing intermetallic compound layer on an outer surface of the contact region, and the intermetallic compound layer covers the contact region, so that the contact region has a reduced tin whisker formation rate when the terminal (200) is connected to the circuit board (400).

9. The electrical assembly according to claim 8, **characterized in that** the terminal comprises:
an intermediate layer (210), containing a conductive metal as a terminal base material;
a first layer (220), covering the intermediate layer (210) and containing nickel; and a second layer (230), covering the first layer (220) and containing tin.

10. The electrical assembly according to claim 9, **characterized in that** the wavelength and predetermined time of the laser irradiation are selected such that at the contact region, the temperature of the second layer (230) rises above the melting point of tin and melting occurs, and then the tin from the second layer (230) and the nickel from the first layer (220) mutually diffuse and then are re-solidified to form an intermetallic compound layer containing nickel and tin, wherein the intermetallic compound layer is larger than the contact region.
